# EUROPEAN PATENT APPLICATION

(11) **EP 3 758 055 A1**
(43) Date of publication of application: **30.12.2020**
(21) Application number: 20166238.4
(22) Date of filing: 27.03.2020
(51) Int. Cl.: H01L 21/8234, H01L 27/088, H01L 29/66, H01L 21/822, H01L 27/06

(54) **DEVICES WITH AIR GAPPING WITHIN AND BETWEEN STACKED TRANSISTORS AND PROCESS FOR PROVIDING SUCH**

(30) Priority: 27.06.2019 US 201916455671
(71) Applicant: Intel Corporation, Santa Clara, CA 95054 (US)
(72) Inventor: MANNEBACH, Ehren, Tigard, OR 97223 (US); LILAK, Aaron, Beaverton, OR 97007 (US); PHAN, Anh, Beaverton, OR 97007 (US); YOO, Hui Jae, Hillsboro, OR 97124-6463 (US); MORROW, Patrick, Portland, OR 97229 (US); HUANG, Cheng-Ying, Hillsboro, OR 97124 (US); RACHMADY, Willy, Beaverton, OR 97007 (US); DEWEY, Gilbert, Beaverton, OR 97006 (US)
(74) Representative: HGF

(57) **Abstract**

A device is disclosed. The device includes a first gate conductor (111b) , a first source-drain region (109b, 109c) adjacent a first side of the first gate conductor and a second source-drain region (109b, 109c) adjacent a second side of the first gate conductor, a second gate conductor (111a) below the first gate conductor, a third source-drain region (109a, 109c) below the first source-drain region and adjacent a first side of the second gate conductor and a fourth source-drain region (109a, 109c) below the second source-drain region and adjacent a second side of the second gate conductor, a first air gap space (123) between the first source-drain region and a first side of the first gate conductor and a second air gap space (123) between the second source-drain region and the second side of the second gate conductor. A planar dielectric layer is formed above the first gate conductor.

## Description

### TECHNICAL FIELD

Embodiments of the disclosure pertain to devices with air gapping and, in particular, to devices with air gapping between stacked transistors.

### BACKGROUND

In previous approaches, in order to reduce the capacitance between adjacent gate and source/drain regions, transistor designers have relied upon the deposition of low-k spacer materials or increases in the thickness of isolation materials. However, increasing the thickness of isolation material between stacked transistors increases the difficulty in fabricating the structures (e.g., aspect ratios for etches and film depositions are higher). Moreover, porous low-k materials may not be compatible with high temperature downstream processing of the stacked transistors.

### BRIEF DESCRIPTION OF THE DRAWINGS

FIG. 1 illustrates a semiconductor structure with air gapping between stacked transistors according to an embodiment.
FIGS. 2A-2E illustrate cross-sections of a semiconductor structure at stages during a process of fabricating a semiconductor structure with air gapping between stacked transistors according to an embodiment.
FIGS. 3A-3D illustrate cross-sections of a semiconductor structure at stages during a process of fabricating a semiconductor structure with air gapping between stacked transistors according to an embodiment.
FIGS. 4A-4D illustrate cross-sections of a semiconductor structure at stages during a process of fabricating a semiconductor structure with air gapping between stacked transistors according to an embodiment.
FIGS. 5A-5D illustrate cross-sections of a semiconductor structure at stages during a process of fabricating a semiconductor structure with air gapping between stacked transistors according to an embodiment.
FIG. 6 illustrates a flowchart of a method of forming a semiconductor structure with air gapping between stacked transistors during fabrication according to an embodiment.
FIG. 7 illustrates a computer system according to an embodiment.
FIG. 8 illustrates an interposer that includes one or more implementations of an embodiment.

### DESCRIPTION OF THE EMBODIMENTS

Devices with air gapping of gate spacers and other dielectrics is described. It should be appreciated that although embodiments are described herein with reference to example devices with air gapping of gate spacers and other dielectrics implementations, the disclosure is more generally applicable to devices with air gapping of gate spacers and other dielectrics implementations as well as other type devices with air gapping of gate spacers and other dielectrics implementations. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

Certain terminology may also be used in the following description for the purpose of reference only, and thus are not intended to be limiting. For example, terms such as "upper", "lower", "above", and "below" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

In previous approaches, in order to reduce the capacitance between adjacent gate and source/drain regions, transistor designers have relied upon the deposition of low-k spacer materials or increases in the thickness of isolation materials. However, increasing the thickness of an isolation layer between stacked transistors increases the difficulty in fabricating the structures (e.g., aspect ratios for etches and film depositions are higher). Moreover, porous low-k materials may not be compatible with high-temperature downstream processing of the stacked transistors.

An approach that addresses the shortcomings of previous approaches is disclosed herein. As part of a disclosed approach, the dielectric between stacked transistors are replaced with air gaps or low-k materials to reduce parasitic capacitances.

In an embodiment, sacrificial material is selectively removed from between gates and sources/drains and/or isolation walls to expose the dielectrics that isolate the top and bottom transistors in a stacked device. In particular, both vertical and lateral dielectrics can be removed and/or replaced or partially replaced. In an embodiment, selective etches are performed from the back side of the wafers. When exposed, the dielectrics can be removed and/or replaced or partially replaced with a low-k material. In an embodiment, the air gaps that are created (or the low-k materials that replace the dielectrics) between stacked transistors reduce parasitic capacitance between the top and bottom devices, and thereby improve device performance.

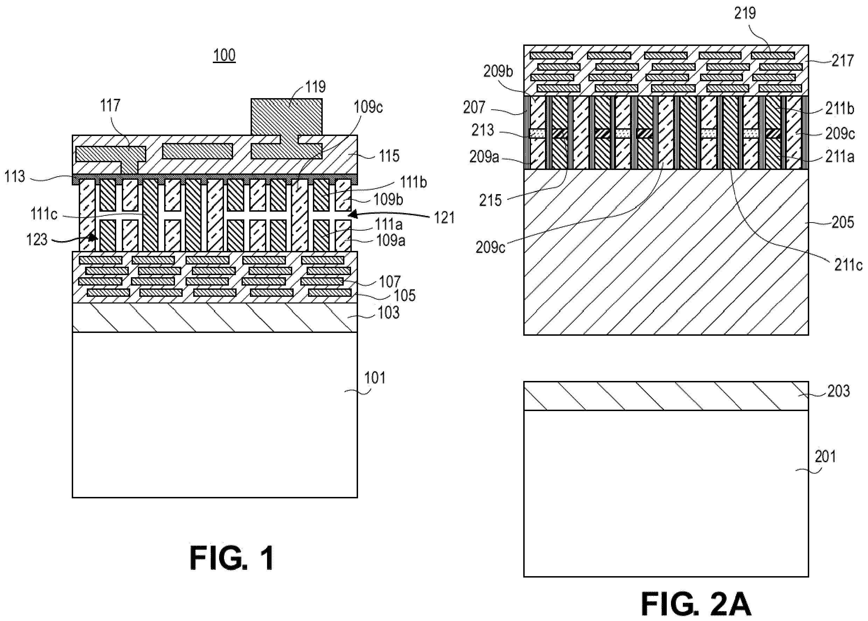

FIG. 1 shows a semiconductor structure 100 with air gapping of dielectrics between stacked transistors according to an embodiment. In FIG. 1, the semiconductor structure 100 includes carrier 101, adhesive material 103, dielectric 105, interconnect layers 107, lower source-drain regions 109a, upper source-drain regions 109b, source-drain regions 109c, lower gate regions 111a, upper gate regions 111b, gate regions 111c, capping layer 113, dielectric 115, interconnect layers 117, power bump 119, horizontal air-gaps 121 and vertical air-gaps 123.

Referring to FIG. 1, in an embodiment, the adhesive layer 103 can be formed on carrier 101. In an embodiment, the dielectric layer 105 can be formed on the adhesive layer 103. In an embodiment, the interconnect layers 107 can be formed in the dielectric layer 105. In an embodiment, the lower gate regions 111a can be formed on the dielectric layer 105. In an embodiment, the upper gate regions 111b can be formed above the lower gate regions 111a and can be separated from the lower gate regions 111a by horizontal air-gap 121. In an embodiment, the gate regions 111c can be formed on the dielectric layer 105 and can extend upward to capping layer 113. In an embodiment, the lower source-drain regions 109a can be formed on the dielectric layer 105. In an embodiment, the upper source-drain regions 109b can be formed above the lower source-drain regions 109a and can be separated from the lower source-drain regions 109a by the horizontal air gap 121. In an embodiment, the source-drain regions 109c can be formed on the dielectric layer 105 and can extend upward to capping layer 113. In an embodiment, the capping layer 113 can be formed above the upper gate regions 109b, the gate regions 109c, the upper source-drain regions 111b and the source-drain regions 111c. In an embodiment, the dielectric layer 115 can be formed on the capping layer 113. In an embodiment, the interconnect layers 117 can be formed in the dielectric layer 115. In an embodiment, the power bump 119 can be formed on the dielectric layer 115 and can be connected to the interconnect layers 117. In an embodiment, the vertical air-gaps 123 separate the gate regions (111a, 111b and 111c) from the source-drain regions (109a, 109b and 109c) that are set apart from them in a lateral direction and extend from the top surface of the dielectric 105 to the capping layer 113. In an embodiment, a mechanically stabilizing layer (not shown) may or may not be used.

In an embodiment the carrier 101 can be formed from Si. In other embodiments the carrier 101 can be formed from other materials. In an embodiment, the adhesive layer 103 can be formed from a Si-based dielectric such as SiOx, SiN, SiON, C-doped SiOx, C-doped SiN, or C-doped SiOCN. In other embodiments the adhesive layer 103 can be formed from other materials. In an embodiment, the dielectric layer 105 can be formed from silicon dioxide (SiO₂), carbon doped oxide (CDO), silicon nitride, organic polymers such as perfluorocyclobutane or polytetrafluoroethylene, fluorosilicate glass (FSG), organosilicates such as silsesquioxane, siloxane, or organosilicate glass. In other embodiments the dielectric layer 105 can be formed from other materials. In an embodiment, the interconnect layer 107 can be formed from copper or aluminum. In other embodiments, the interconnect layer 107 can be formed from other materials. In an embodiment, the gate regions (111a, 111b and 111c) can be formed from hafnium, zirconium, titanium, tantalum, aluminum, alloys of these metals, or carbides of these metals such as hafnium carbide, zirconium carbide, titanium carbide, tantalum carbide, or aluminum carbide. In other embodiments the gate regions (111a, 111b and 111c) can be formed from other materials. In an embodiment, the source-drain regions (109a, 109b and 109c) can be formed from a silicon alloy such as silicon germanium or silicon carbide. In some implementations the epitaxially deposited silicon alloy may be doped in situ with dopants such as boron, arsenic, or phosphorous. In further embodiments, the source-drain regions (109a, 109b and 109c) may be formed using one or more alternate semiconductor materials such as germanium or a group III-V material or alloy. And in further embodiments, one or more layers of metal and/or metal alloys may be used to form the source-drain regions. In other embodiments the source-drain regions (109a, 109b and 109c) can be formed from other materials. In an embodiment, the capping layer 113 can be hermetic and electrically insulating. In an embodiment, the capping layer 113 can be formed from a Si-based dielectric such as SiOx, SiN, SiON, C-doped SiOx, C-doped SiN, or C-doped SiON. In other embodiments, the capping layer 113 can be formed from other materials. In an embodiment, the dielectric layer 115 can be formed from silicon dioxide (SiO₂), carbon doped oxide (CDO), silicon nitride, organic polymers such as perfluorocyclobutane or polytetrafluoroethylene, fluorosilicate glass (FSG), and organosilicates such as silsesquioxane, siloxane, or organosilicate glass. In other embodiments, the dielectric layer 115 can be formed from other materials. In an embodiment, the interconnect layers 117 can be formed from copper or aluminum. In other embodiments, the interconnect layers 117 can be formed from other materials. In an embodiment, the power bump 119 can be formed from copper or aluminum. In other embodiments, the power bump 119 can be formed from other materials.

In operation, when transistors included in semiconductor structure 100 are turned on, the low parasitic capacitances that are facilitated by the air gapping and/or replacement of the gate spacer dielectric, and the isolation layer dielectric between stacked transistors (formed as described herein), enables high speed and low power consumption switching. In addition, because penalties associated with increasing dielectric thickness are avoided, further performance enhancements can be realized. For example, transistor contact area can be increased (which decreases resistance) and gate pitch can be shrunk (which facilitates scaling).

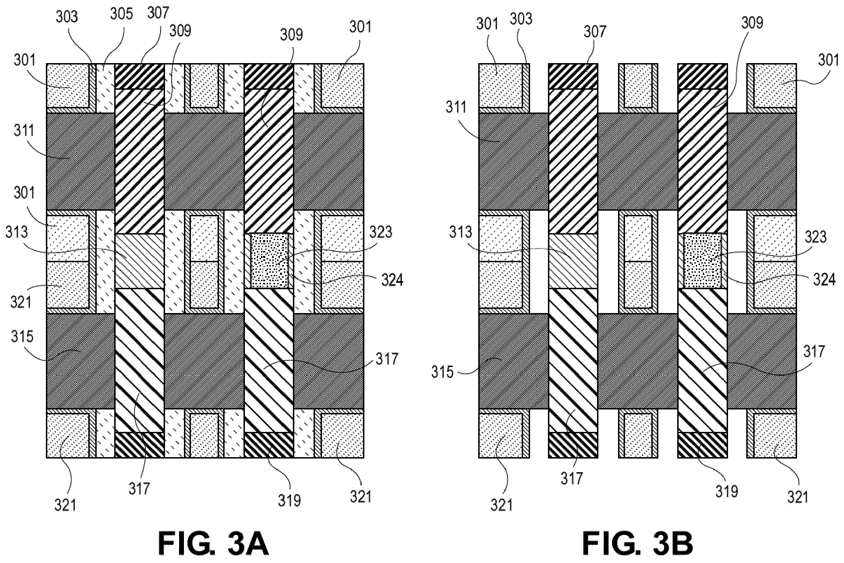

In an embodiment, as part of the process for forming the semiconductor structure 100 gate spacers and/or isolation walls are selectively removed following the exposure of formerly unexposed components of the stacked transistors. The removal of the gate spacers and/or isolation walls exposes the dielectric that isolates the top and bottom transistors. Then the dielectric that isolates the top and bottom transistors is etched out. After the desired air gaps/low-k replacements are formed, a non-conformal dielectric material is deposited to seal the air gaps/low-k materials. Backside interconnects can then be formed. FIGS. 2A-2E illustrate the process flow and FIGS. 3A-3D, 4A-4D and 5A-5D show more detailed views of the stacked transistors during the air gap formation/low-k material replacement process for various combinations of material etches. It should be noted that FIGS. 3A-3D, 4A-4D and 5A-5D depict fin-based transistors, however embodiments apply equally well to other type devices such as nanowire- or nanoribbon-based devices. In an embodiment, where ribbon/wire based transistors are used, each of the strata of stacked devices can include any number (and different numbers) of ribbons/wires. In an embodiment, respective strata of stacked devices can contain the same or different types of devices. For example, a first strata and a second strata can both contain fin based devices or the first strata can contain fin based devices and the second strata can contain ribbon based devices, or the first strata can contain nanowire based devices and the second strata can contain fin based devices, etc. In an embodiment, vias to the bottom transistors may be fabricated in a single-damascene style before the air gapping/material replacement operations described herein. In other embodiments, vias to the bottom transistors may be fabricated in other manners.

As referenced above, FIGS. 2A-2E illustrate cross-sections of a semiconductor structure at stages during a process of fabricating a semiconductor structure with air gapping between stacked transistors according to an embodiment. Referring to FIG. 2A, after one or more operations the semiconductor structure includes carrier 201, adhesive 203, wafer 205, spacers 207, lower source-drain regions 209a, upper source-drain regions 209b, source-drain regions 209c, lower gate regions 211a, upper gate regions 211b, gate regions 211c, source-drain isolation layers 213, gate isolation layers 215, dielectric layer 217, and interconnect layers 219.

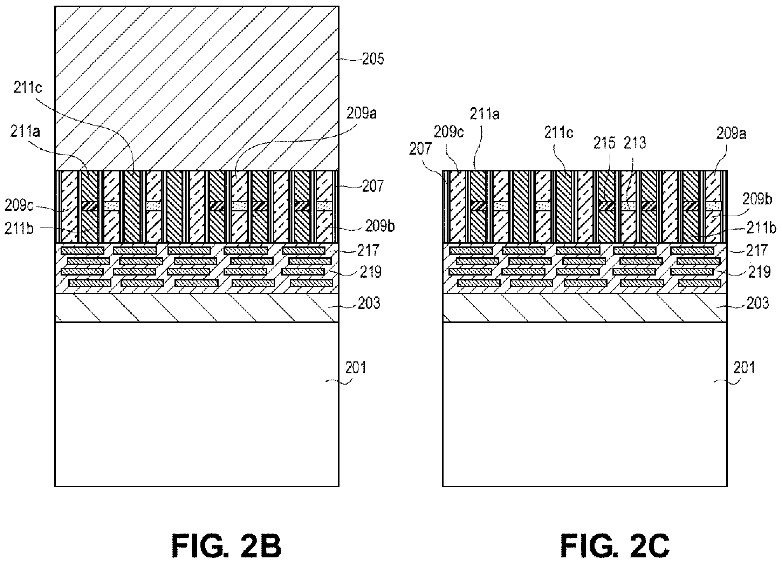

Referring to FIG. 2B, after one or more operations that result in the cross-section of the semiconductor structure shown in FIG. 2A, the device wafer 205 including the transistors (that include source-drain regions 209a-209c and gate regions 211a-211c) that are formed thereon is flipped and bonded to the carrier 201 by the adhesive 203. In an embodiment, the device wafer 205 can be formed from a bulk silicon or a silicon-on-insulator substructure. In other implementations, the device wafer 205 may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V or group IV materials. In still other embodiments, the device wafer can be formed from other materials.

Referring to FIG. 2C, after one or more operations that result in the cross-section of the semiconductor structure shown in FIG. 2B, the device wafer 205 is removed. In an embodiment, the removal of the device wafer 205 exposes gate spacers 207, source-drain regions 209a and 209c and gate regions 211a and 211c.

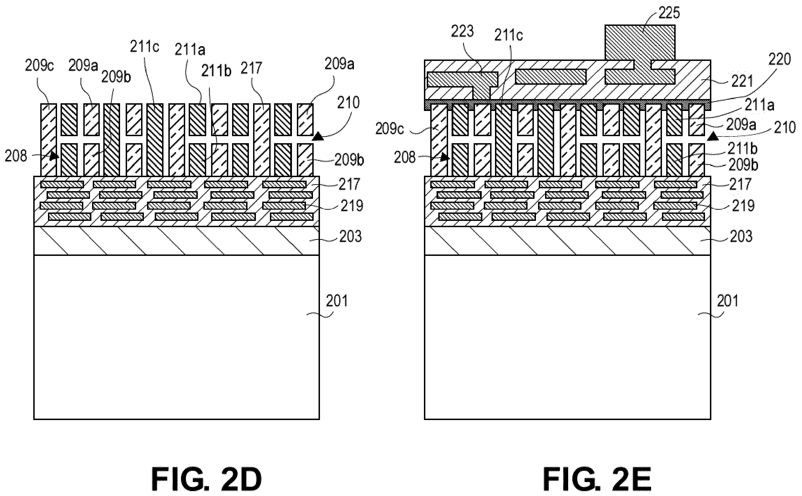

Referring to FIG. 2D, after one or more operations that result in the cross-section of the semiconductor structure shown in FIG. 2C, the material used to form the gate spacers 207 is removed. Subsequently, the source-drain isolation layers 213 and the gate isolation layers 215 are removed. In an embodiment, the gate spacers 207, the source-drain isolation layers 213, and the gate isolation layers 215 can be removed by etching. In other embodiments, the gate spacers 207, the source-drain isolation layers 213, and the gate isolation layers 215 can be removed in other manners. In an embodiment, the gate spacers 207, the source-drain isolation layers 213, and the gate isolation layers 215 can be formed from oxynitride doped with carbon. In other embodiments, the gate spacers 207, the source-drain isolation layers 213, and the gate isolation layers 215 can be formed from other material. In an embodiment, if the gate spacers 207, the source-drain isolation layers 213, and the gate isolation layers 215 are purely sacrificial, they can be formed from almost any material that can be removed selectively with respect to the other materials (e.g., metal oxides). In an embodiment, based on the removal of the gate spacers 207, the source-drain isolation layers 213, and the gate isolation layers 215, vertical air gaps 208 and horizontal air gaps 210 are formed.

Referring to FIG. 2E, after one or more operations that result in the cross-section of the semiconductor structure shown in FIG. 2D, the air gaps (vertical air gaps 208 and horizontal air gaps 210) are capped with a capping layer 220 and thereafter, dielectric layer 221, backside interconnect layers 223, and power wires and bumps 225 are formed. In an embodiment, the capping layer 220 can be formed using a non-conformal deposition process. In an embodiment, the capping layer 220 can be hermetic and electrically insulating. For example, in an embodiment, the capping layer 220 can be formed from a Si-based dielectric such as SiOx, SiN, SiON, C-doped SiOx, C-doped SiN, or C-doped SiON. In other embodiments, the capping layer 220 can be formed from other materials.

FIGS. 3A-3D illustrate cross-sections of a semiconductor structure at stages during a process of fabricating a semiconductor structure with air gapping between stacked transistors according to an embodiment. FIG. 3A shows a gate cut centered view of stacked transistors after exposure of the bottom transistors (FIG. 2C). Referring to FIG. 3A, the semiconductor structure includes first layer gate conductors 301, high-k dielectric 303, gate spacers 305, first layer contacts 307, first layer source-drain regions 309, first layer channel 311, source-drain isolation layer 313, second layer channel 315, second layer source-drain regions 317, second layer contacts 319, second layer gate conductors 321, top-to-bottom source-drain via 323 (optional), source-drain via dielectric 324. In an embodiment, the materials used to form the first layer channel 311 and the second layer channel 315 can be the same or can be different. For example, in an embodiment, both the first layer channel 311 and the second layer channel 315 can be formed from silicon. In other embodiments, the first layer channel 311 can be formed from silicon and the second layer channel 315 can be formed from germanium, or vice versa. In still other embodiments, the first layer channel 311 and the second layer channel 315 can be formed from other materials.

Referring to FIG. 3B, after one or more operations that result in the cross-section shown in FIG. 3A, the gate spacers 305 are removed. In an embodiment, the gate spacers 305 can be removed in a manner that exposes the dielectric material that isolates the top and bottom transistor contacts such as source-drain isolation layer 313 as well as other dielectric material such as source-drain via dielectric 324. In an embodiment, the gate spacers 305 can be removed by an isotropic etch. In an embodiment, the isotropic etch can be a vapor phase isotropic etch. In other embodiments, the isotropic etch can be other types of isotropic etch.

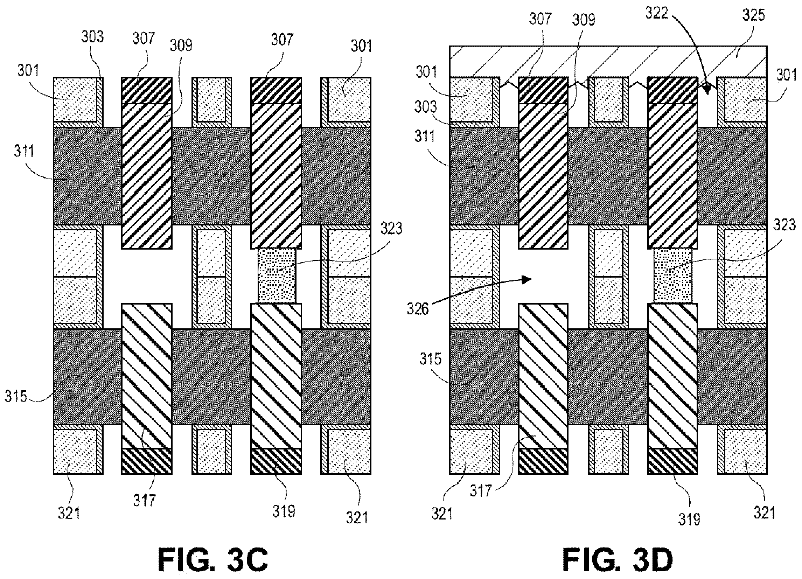

Referring to FIG. 3C, after one or more operations that result in the cross-section shown in FIG. 3B, the source-drain isolation layer 313 and the source-drain via dielectric 324 are removed through the openings where the gate spacers 305 were previously located. In an embodiment, the source-drain isolation layer 313 and the source-drain via dielectric 324 can be removed by an isotropic etch. In an embodiment, the isotropic etch can be a vapor phase isotropic etch. In other embodiments, the isotropic etch can be other types of isotropic etch.

Referring to FIG. 3D, after one or more operations that result in the cross-section shown in FIG. 3C, air gaps 322 and 326 that are formed by the removal of the gate spacers 305, the source-drain isolation layer 313 and the source-drain via dielectric 324 are capped with a capping layer 325 before additional downstream processing. In an embodiment, the capping layer 325 can be formed by non-conformal deposition (the non-conformal deposition is indicated by the portions of the capping layer 325 that are shown extending into the air gaps 322). In other embodiments, the capping layer 325 can be formed in other manners.

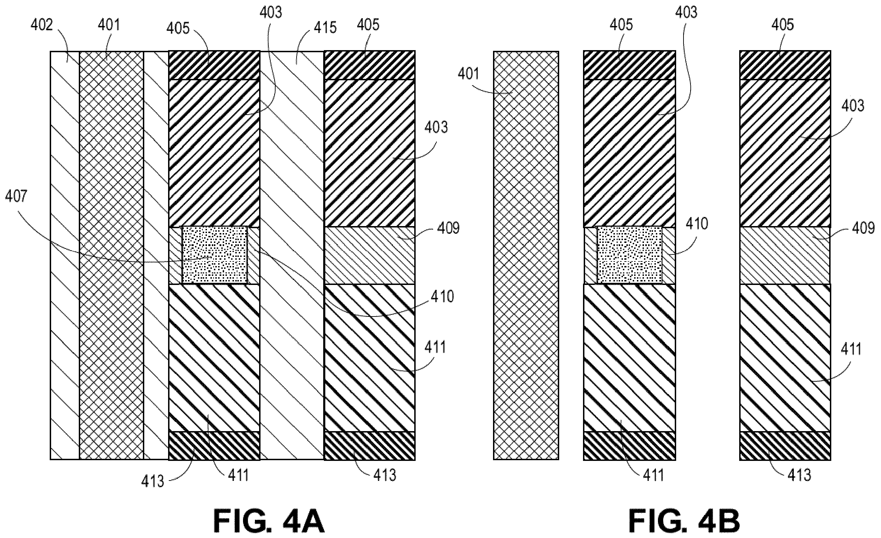

FIGS. 4A-4D illustrate cross-sections of a semiconductor structure at stages during a process of fabricating a semiconductor structure with air gapping between stacked transistors according to an embodiment. FIG. 4A shows a fin cut view of the stacked transistor semiconductor structure centered in the source-drain region after exposure of the bottom transistors (FIG. 2C).

Referring to FIG. 4A, the stacked semiconductor structure includes isolation wall core 401, isolation wall 402, first layer source-drain regions 403, first layer contacts 405, top-to-bottom source-drain via 407, top-to-bottom isolation dielectric 409, source drain via dielectric 410, second layer source-drain region 411, second layer contact 413 and isolation wall 415. In an embodiment, the isolation wall core 401 is formed in the isolation wall 402.

Referring to FIG. 4B, after one or more operations that result in the cross-section shown in FIG. 4A, the isolation walls 402 and 415 are removed. In an embodiment, the materials in the isolation walls can be removed to expose the dielectric between the first and second layer source-drain regions. More specifically, the removal of the isolation walls 402 exposes the top-to-bottom isolation dielectric 409 and source-drain via dielectric 410. In an embodiment, the isolations walls 402 and 415 can be removed by an isotropic etch. In an embodiment, the isotropic etch can be a vapor phase isotropic etch. In other embodiments, the isotropic etch can include other types of isotropic etch.

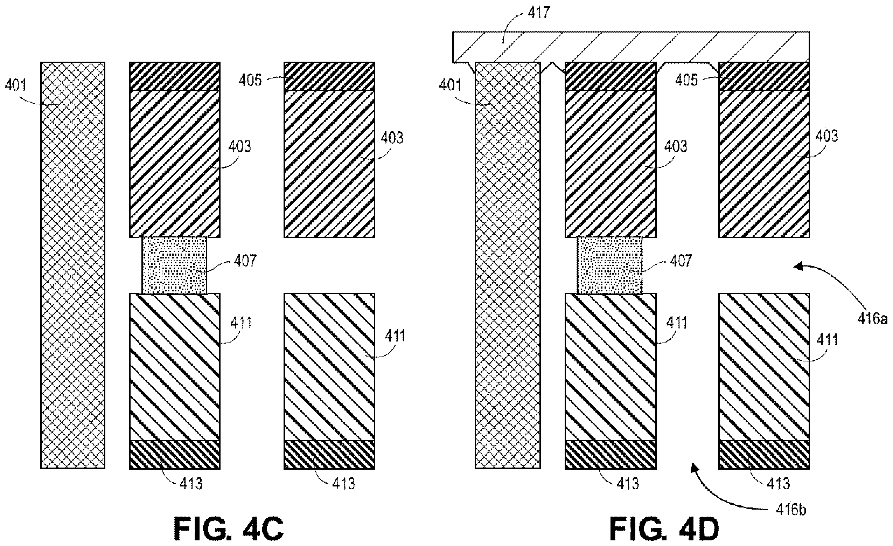

Referring to FIG. 4C, after one or more operations that result in the cross-section shown in FIG. 4B, the top-to-bottom isolation dielectric 409 and the source-drain via dielectric 410 are removed through the openings where the gate spacer was previously located (see FIGS. 3A-3D). In an embodiment, the top-to-bottom dielectric 409 and the source-drain via dielectric 410 can be removed by an isotropic etch. In an embodiment, the isotropic etch can be a vapor phase isotropic etch. In other embodiments, the isotropic etch can be other types of isotropic etch.

Referring to FIG. 4D, after one or more operations that result in the cross-section shown in FIG. 4C, air gaps 416a and 416b formed by processes associated with FIGS. 4B and 4C are capped with a capping layer 417 before additional downstream processing. In an embodiment, the capping layer 417 can be formed by non-conformal deposition. In other embodiments, the capping layer 417 can be formed in other manners.

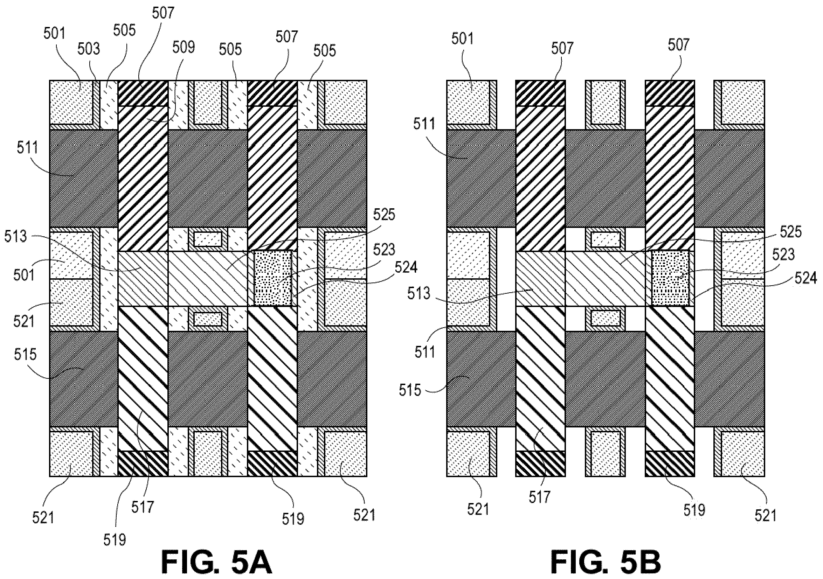

FIGS. 5A-5D illustrate cross-sections of a semiconductor structure at stages during a process of fabricating a semiconductor structure with air gapping between stacked transistors according to an embodiment. FIG. 5A shows a gate cut centered view of a stacked transistor semiconductor structure after exposure of the bottom transistors (FIG. 2C).

Referring to FIG. 5A, the stacked transistor semiconductor structure includes a first layer gate conductors 501, high-k dielectric 503, gate spacers 505, contact metal 507, first layer source-drain regions 509, first layer channel 511, source-drain isolation layers 513, second layer channel 515, second layer source-drain regions 517, second layer contacts 519, second layer gate conductors 521, top-to-bottom source-drain via 523 (optional), source-drain via dielectric 524, and top-to-bottom gate isolation layer 525.

Referring to FIG. 5B, after one or more operations that result in the cross-section shown in FIG. 5A, the gate spacers 505 are removed. In an embodiment, the gate spacers 505 are removed to expose dielectric material, e.g., top-to-bottom gate isolation layer 525 that isolates the first and the second layer gate conductors 501 and 521, the source-drain isolation layer 513, and the source-drain via dielectric 524. In an embodiment, the gate spacers 505 can be removed by an isotropic etch. In an embodiment, the isotropic etch can be a vapor phase isotropic etch. In other embodiments, the isotropic etch can be other types of isotropic etch.

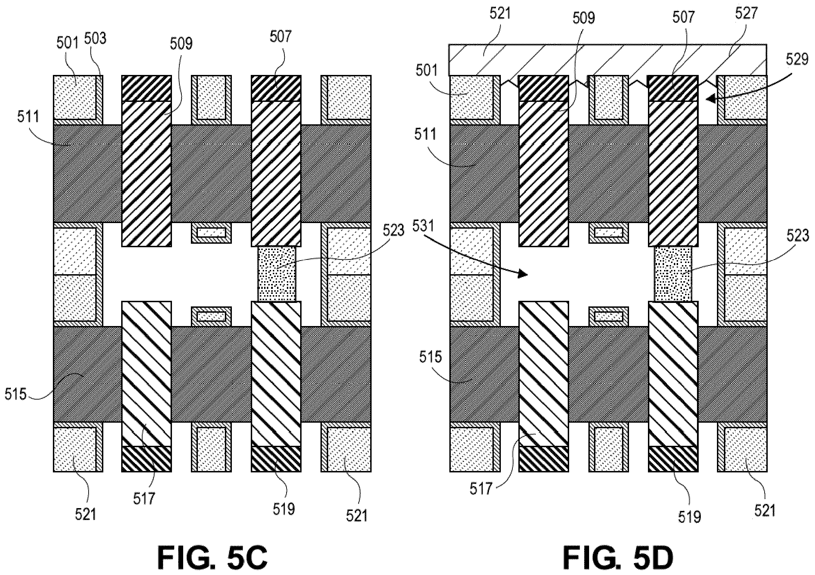

Referring to FIG. 5C, after one or more operations that result in the cross-section shown in FIG. 5B, the top-to-bottom gate isolation layer 525, the source-drain isolation layer 513, and the source-drain via dielectric 524 are etched out through the openings where the gate spacers 505 were previously located. In an embodiment, the top-to-bottom gate isolation layer 525, the source-drain isolation layer 513, and the source-drain via dielectric 524 can be removed by an isotropic etch. In an embodiment, the isotropic etch can be a vapor phase isotropic etch. In other embodiments, the isotropic etch can be other types of isotropic etch.

Referring to FIG. 5D, after one or more operations that result in the cross-section shown in FIG. 5C, air gaps 529 and 531 formed by the processes associated with FIG. 5B and FIG. 5C are capped with a capping layer 527 before additional downstream processing. In an embodiment, the capping layer 527 can be formed by non-conformal deposition. In other embodiments, the capping layer 527 can be formed in other manners. It should be appreciated that the process of FIGS. 5A-5D can also be performed by etching through isolating walls, as shown in FIGS. 4A-4D.

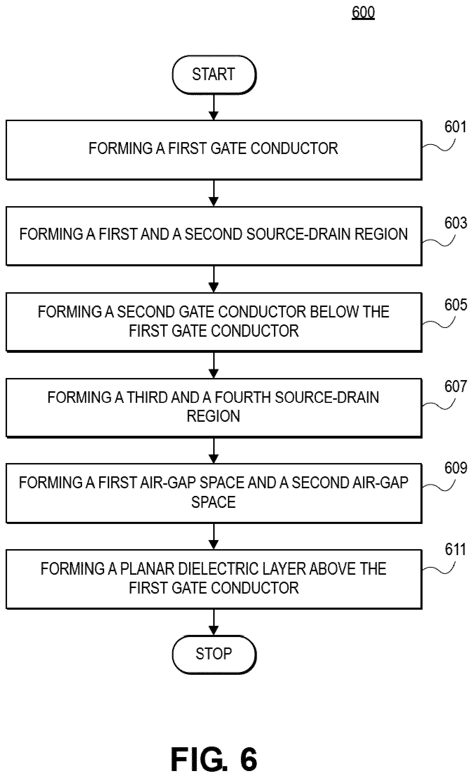

FIG. 6 shows a method for forming a semiconductor structure with backside air gapping of gate spacers and other dielectrics according to an embodiment. Referring to FIG. 6, the method includes, at 601, forming a first gate conductor. At 603, forming a first source-drain region adjacent a first side of the first gate conductor and a second source-drain region adjacent a second side of the first gate conductor. At 605, forming a second gate conductor below the first gate conductor. At 607, forming a third source-drain region below the first source-drain region and adjacent a first side of the second gate conductor and a fourth source-drain region below the second source-drain region and adjacent a second side of the second gate conductor. At 609, forming a first air gap space between the first source-drain region and a first side of the first gate conductor and a second air gap space between the second source-drain region and the second side of the first gate conductor. At 611, forming a planar dielectric layer above the first gate conductor.

Implementations of embodiments of the invention may be formed or carried out on a substrate, such as a semiconductor substrate. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V or group IV materials. Although a few examples of materials from which the substrate may be formed are described here, any material that may serve as a foundation upon which a semiconductor device may be built falls within the spirit and scope of the present invention.

A plurality of transistors, such as metal-oxide-semiconductor field-effect transistors (MOSFET or simply MOS transistors), may be fabricated on the substrate. In various implementations of the invention, the MOS transistors may be planar transistors, nonplanar transistors, or a combination of both. Nonplanar transistors include FinFET transistors such as double-gate transistors and tri-gate transistors, and wrap-around or all-around gate transistors such as nanoribbon and nanowire transistors. Although the implementations described herein may illustrate only planar transistors, it should be noted that the invention may also be carried out using nonplanar transistors.

Each MOS transistor includes a gate stack formed of at least two layers, a gate dielectric layer and a gate electrode layer. The gate dielectric layer may include one layer or a stack of layers. The one or more layers may include silicon oxide, silicon dioxide (SiO₂) and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The gate electrode layer is formed on the gate dielectric layer and may consist of at least one P-type workfunction metal or N-type workfunction metal, depending on whether the transistor is to be a PMOS or an NMOS transistor. In some implementations, the gate electrode layer may consist of a stack of two or more metal layers, where one or more metal layers are workfunction metal layers and at least one metal layer is a fill metal layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a workfunction that is between about 3.9 eV and about 4.2 eV.

In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the invention, the gate electrode may consist of a combination of U-shaped structures and planar, non-U-shaped structures. For example, the gate electrode may consist of one or more U-shaped metal layers formed atop one or more planar, non-U-shaped layers.

In some implementations of the invention, a pair of sidewall spacers may be formed on opposing sides of the gate stack that bracket the gate stack. The sidewall spacers may be formed from a material such as silicon nitride, silicon oxide, silicon carbide, silicon nitride doped with carbon, and silicon oxynitride. Processes for forming sidewall spacers are well known in the art and generally include deposition and etching process steps. In an alternate implementation, a plurality of spacer pairs may be used, for instance, two pairs, three pairs, or four pairs of sidewall spacers may be formed on opposing sides of the gate stack.

As is well known in the art, source and drain regions are formed within the substrate adjacent to the gate stack of each MOS transistor. The source and drain regions are generally formed using either an implantation/diffusion process or an etching/deposition process. In the former process, dopants such as boron, aluminum, antimony, phosphorous, or arsenic may be ion-implanted into the substrate to form the source and drain regions. An annealing process that activates the dopants and causes them to diffuse further into the substrate typically follows the ion implantation process. In the latter process, the substrate may first be etched to form recesses at the locations of the source and drain regions. An epitaxial deposition process may then be carried out to fill the recesses with material that is used to fabricate the source and drain regions. In some implementations, the source and drain regions may be fabricated using a silicon alloy such as silicon germanium or silicon carbide. In some implementations the epitaxially deposited silicon alloy may be doped in situ with dopants such as boron, arsenic, or phosphorous. In further embodiments, the source and drain regions may be formed using one or more alternate semiconductor materials such as germanium or a group III-V material or alloy. And in further embodiments, one or more layers of metal and/or metal alloys may be used to form the source and drain regions.

One or more interlayer dielectrics (ILD) are deposited over the MOS transistors. The ILD layers may be formed using dielectric materials known for their applicability in integrated circuit structures, such as low-k dielectric materials. Examples of dielectric materials that may be used include, but are not limited to, silicon dioxide (SiO₂), carbon doped oxide (CDO), silicon nitride, organic polymers such as perfluorocyclobutane or polytetrafluoroethylene, fluorosilicate glass (FSG), and organosilicates such as silsesquioxane, siloxane, or organosilicate glass. The ILD layers may include pores or air gaps to further reduce their dielectric constant.

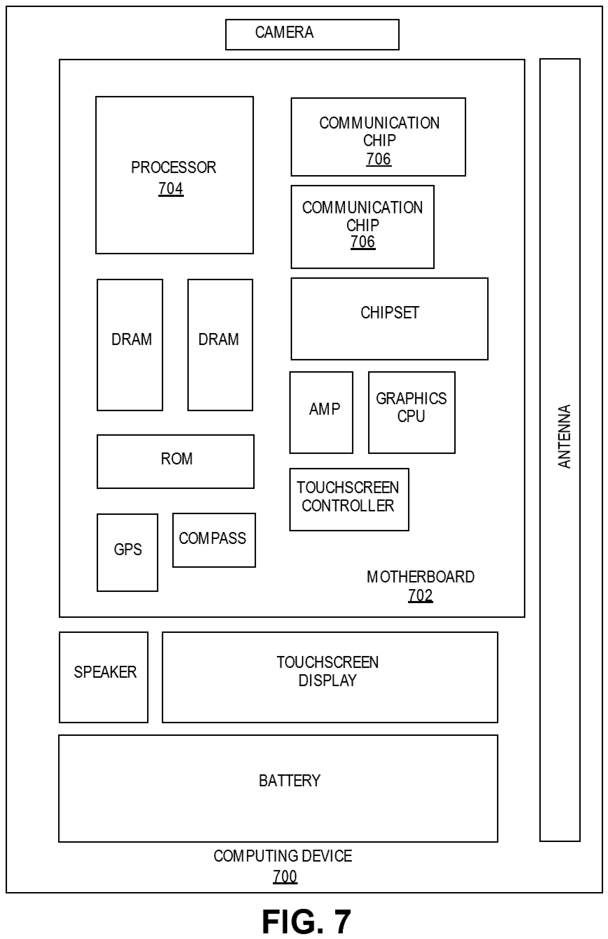

FIG. 7 illustrates a computing device 700 in accordance with one implementation of the invention. The computing device 700 houses a board 702. The board 702 may include a number of components, including but not limited to a processor 704 and at least one communication chip 706. The processor 704 is physically and electrically coupled to the board 702. In some implementations the at least one communication chip 706 is also physically and electrically coupled to the board 702. In further implementations, the communication chip 706 is part of the processor 704.

Depending on its applications, computing device 700 may include other components that may or may not be physically and electrically coupled to the board 702. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 706 enables wireless communications for the transfer of data to and from the computing device 700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 706 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 700 may include a plurality of communication chips 706. For instance, a first communication chip 706 may be dedicated to shorter range wireless communications such as Wi-Fi and Bluetooth and a second communication chip 706 may be dedicated to longer range wireless communications such as GPS, EDGE, GPRS, CDMA, WiMAX, LTE, Ev-DO, and others.

The processor 704 of the computing device 700 includes an integrated circuit die packaged within the processor 704. In some implementations of the invention, the integrated circuit die of the processor includes one or more devices, such as MOS-FET transistors built in accordance with implementations of the invention. The term "processor" may refer to any device or portion of a device that processes electronic data from registers and/or memory to transform that electronic data into other electronic data that may be stored in registers and/or memory.

The communication chip 706 also includes an integrated circuit die packaged within the communication chip 706. In accordance with another implementation of the invention, the integrated circuit die of the communication chip includes one or more devices, such as MOS-FET transistors built in accordance with implementations of the invention.

In further implementations, another component housed within the computing device 700 may contain an integrated circuit die that includes one or more devices, such as MOS-FET transistors built in accordance with implementations of the invention.

In various implementations, the computing device 700 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 700 may be any other electronic device that processes data.

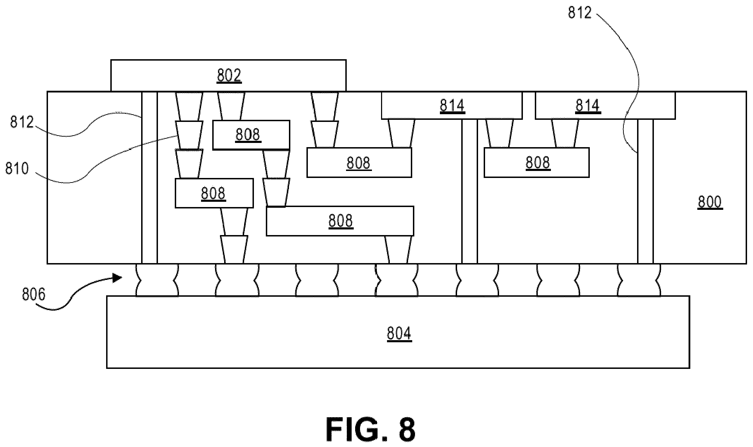

FIG. 8 illustrates an interposer 800 that includes one or more embodiments of the invention. The interposer 800 is an intervening substrate used to bridge a first substrate 802 to a second substrate 804. The first substrate 802 may be, for instance, an integrated circuit die. The second substrate 804 may be, for instance, a memory module, a computer motherboard, or another integrated circuit die. Generally, the purpose of an interposer 800 is to spread a connection to a wider pitch or to reroute a connection to a different connection. For example, an interposer 800 may couple an integrated circuit die to a ball grid array (BGA) 806 that can subsequently be coupled to the second substrate 804. In some embodiments, the first and second substrates 802/804 are attached to opposing sides of the interposer 800. In other embodiments, the first and second substrates 802/804 are attached to the same side of the interposer 800. And in further embodiments, three or more substrates are interconnected by way of the interposer 800.

The interposer 800 may be formed of an epoxy resin, a fiberglass-reinforced epoxy resin, a ceramic material, or a polymer material such as polyimide. In further implementations, the interposer 800 may be formed of alternate rigid or flexible materials that may include the same materials described above for use in a semiconductor substrate, such as silicon, germanium, and other group III-V and group IV materials.

The interposer 800 may include metal interconnects 808 and vias 810, including but not limited to through-silicon vias (TSVs) 812. The interposer 800 may further include embedded devices 814, including both passive and active devices. Such devices include, but are not limited to, capacitors, decoupling capacitors, resistors, inductors, fuses, diodes, transformers, sensors, and electrostatic discharge (ESD) devices. More complex devices such as radiofrequency (RF) devices, power amplifiers, power management devices, antennas, arrays, sensors, and MEMS devices may also be formed on the interposer 800. In accordance with embodiments of the invention, apparatuses or processes disclosed herein may be used in the fabrication of interposer 800.

Although specific embodiments have been described above, these embodiments are not intended to limit the scope of the present disclosure, even where only a single embodiment is described with respect to a particular feature. Examples of features provided in the disclosure are intended to be illustrative rather than restrictive unless stated otherwise. The above description is intended to cover such alternatives, modifications, and equivalents as would be apparent to a person skilled in the art having the benefit of the present disclosure.

The scope of the present disclosure includes any feature or combination of features disclosed herein (either explicitly or implicitly), or any generalization thereof, whether or not it mitigates any or all of the problems addressed herein. Accordingly, new claims may be formulated during prosecution of the present application (or an application claiming priority thereto) to any such combination of features. In particular, with reference to the appended claims, features from dependent claims may be combined with those of the independent claims and features from respective independent claims may be combined in any appropriate manner and not merely in the specific combinations enumerated in the appended claims.

The following examples pertain to further embodiments. The various features of the different embodiments may be variously combined with some features included and others excluded to suit a variety of different applications.
Example embodiment 1: A device, comprising: a first gate conductor; a first source-drain region adjacent a first side of the first gate conductor and a second source-drain region adjacent a second side of the first gate conductor; a second gate conductor below the first gate conductor; a third source-drain region below the first source-drain region and adjacent a first side of the second gate conductor and a fourth source-drain region below the second source-drain region and adjacent a second side of the second gate conductor; a first air gap space between the first source-drain region and a first side of the first gate conductor and a second air gap space between the second source-drain region and the second side of the first gate conductor; and a planar dielectric layer above the first gate conductor.
Example embodiment 2: The device of example embodiment 1, further comprising a third air gap space between the third source-drain region and a first side of the second gate conductor and a fourth air gap space between the fourth source-drain region and a second side of the second gate conductor.
Example embodiment 3: The device of example embodiment 1 or 2, further comprising a first channel associated with the first gate conductor and a second channel associated with the second gate conductor.
Example embodiment 4: The device of example embodiment 3, wherein the first channel is above the second channel.
Example embodiment 5: The device of example embodiment 1, 2, 3, or 4, further comprising an air gap between the first gate conductor and the second gate conductor.
Example embodiment 6: The device of example embodiment 3, 4, or 5, wherein the first channel and the second channel has a nanoribbon, a fin or a nanowire configuration.
Example embodiment 7: The device of example embodiment 1, 2, 3, 4, 5, or 6, further comprising a first interconnect layer above the first gate conductor and a second interconnect layer below the second gate conductor.
Example embodiment 8: A system, comprising: one or more processing components; one or more memory components; and one or more semiconductor devices including at least one of the one or more processing components and the one or more memory components, the one or more semiconductor devices including: a first gate conductor; a first source-drain region adjacent a first side of the first gate conductor and a second source-drain region adjacent a second side of the first gate conductor; a second gate conductor below the first gate conductor; a third source-drain region below the first source-drain region and adjacent a first side of the second gate conductor and a fourth source-drain region below the second source-drain region and adjacent a second side of the first gate conductor; a first air gap space between the first source-drain region and a first side of the first gate conductor and a second air gap space between the second source-drain region and the second side of the first gate conductor; and a planar dielectric layer above the first gate conductor.
Example embodiment 9: The system of example embodiment 8, further comprising a third air gap space between the third source-drain region and a first side of the second gate conductor and a fourth air gap space between the fourth source-drain region and a second side of the second gate conductor.
Example embodiment 10: The system of example embodiment 8 or 9, further comprising a first channel associated with the first gate conductor and a second channel associated with the second gate conductor.
Example embodiment 11: The system of example embodiment 10, wherein the first channel is above the second channel.
Example embodiment 12: The system of example embodiment 8, 9, 10, or 11, further comprising an air gap between the first gate conductor and the second gate conductor.
Example embodiment 13: The system of example embodiment 10, 11, or 12, wherein the first channel and the second channel has a nanoribbon, a fin or a nanowire configuration.
Example embodiment 14: The system of example embodiment 8, 9, 10, 11, 12, or 13, comprising a first interconnect layer above the first gate conductor and a second interconnect layer below the second gate conductor.
Example embodiment 15: A method, comprising: forming a stacked semiconductor structure that includes transistor components and first interconnect components on a first wafer, the transistor components including one or more of one or more gate spacer dielectrics, one or more top-to-bottom source-drain isolation dielectrics and one or more transistor isolation dielectrics; bonding the transistor components and wiring components to a second wafer; removing the first wafer; removing the one or more gate spacer dielectrics; forming air-gaps by removing one or more of the one or more top-to-bottom source-drain isolation dielectrics and the one or more transistor isolation dielectrics; and forming a non-conformal dielectric layer over the air-gaps.
Example embodiment 16: The method of example embodiment 15, further comprising forming a first interlayer dielectric layer wherein the first interconnect components are formed in the first interlayer dielectric.
Example embodiment 17: The method of example embodiment 16, further comprising: forming a second interlayer dielectric on the non-conformal dielectric layer; and forming second interconnect components in the second interlayer dielectric.
Example embodiment 18: The method of example embodiment 15, 16, or 17, further comprising forming an isolation dielectric core material inside one or more of the transistor isolation dielectrics that extends from a bottom surface of the semiconductor structure to a bottom surface of the non-conformal dielectric layer.
Example embodiment 19: A method, comprising: forming a first gate conductor; forming a first source-drain region adjacent a first side of the first gate conductor and a second source-drain region adjacent a second side of the first gate conductor; forming a second gate conductor below the first gate conductor; forming a third source-drain region below the first source-drain region and adjacent a first side of the second gate conductor and a fourth source-drain region below the second source-drain region and adjacent a second side of the first gate conductor; forming a first air gap space between the first source-drain region and a first side of the first gate conductor and a second air gap space between the second source-drain region and the second side of the first gate conductor; and forming a planar dielectric layer above the first gate conductor.
Example embodiment 20: The method of example embodiment 19, further comprising forming a third air gap space between the third source-drain region and a first side of the second gate conductor and a fourth air gap space between the fourth source-drain region and a second side of the second gate conductor.
Example embodiment 21: The method of example embodiment 19, or 20, further comprising forming a first channel associated with the first gate conductor and a second channel associated with the second gate conductor.
Example embodiment 22: The method of example embodiment 21, wherein the first channel is above the second channel.
Example embodiment 23: The method of example embodiment 19, 20, 21, or 22, further comprising an air gap between the first gate conductor and the second gate conductor.
Example embodiment 24: The method of example embodiment 21, 22, or 23, wherein the first channel and the second channel has a nanoribbon, a fin or a nanowire configuration.

## Claims

1. A device, comprising:
a first gate conductor;
a first source-drain region adjacent a first side of the first gate conductor and a second source-drain region adjacent a second side of the first gate conductor;
a second gate conductor below the first gate conductor;
a third source-drain region below the first source-drain region and adjacent a first side of the second gate conductor and a fourth source-drain region below the second source-drain region and adjacent a second side of the second gate conductor;
a first air gap space between the first source-drain region and a first side of the first gate conductor and a second air gap space between the second source-drain region and the second side of the second gate conductor; and
a planar dielectric layer above the first gate conductor.

2. The device of Claim 1, further comprising a third air gap space between the third source-drain region and a first side of the second gate conductor and a fourth air gap space between the fourth source-drain region and a second side of the second gate conductor.

3. The device of Claim 1 or 2, further comprising a first channel associated with the first gate conductor and a second channel associated with the second gate conductor.

4. The device of Claim 3, wherein the first channel is above the second channel.

5. The device of Claim 1, 2, 3 or 4, further comprising an air gap between the first gate conductor and the second gate conductor.

6. The device of Claim 3, 4 or 5, wherein the first channel and the second channel has a nano-ribbon, a fin or a nanowire configuration.

7. The device of Claim 1, 2, 3, 4, 5 or 6, further comprising a first wiring layer above the first gate conductor and a second wiring layer below the second gate conductor.

8. A method, comprising:
forming a first gate conductor;
forming a first source-drain region adjacent a first side of the first gate conductor and a second source-drain region adjacent a second side of the first gate conductor;
forming a second gate conductor below the first gate conductor;
forming a third source-drain region below the first source-drain region and adjacent a first side of the second gate conductor and a fourth source-drain region below the second source-drain region and adjacent a second side of the second gate conductor;
forming a first air gap space between the first source-drain region and a first side of the first gate conductor and a second air gap space between the second source-drain region and the second side of the first gate conductor; and
forming a planar dielectric layer above the first gate conductor.

9. The method of Claim 8, further comprising forming a third air gap space between the third source-drain region and a first side of the second gate conductor and a fourth air gap space between the fourth source-drain region and a second side of the second gate conductor.

10. The method of Claim 8 or 9, further comprising forming a first channel associated with the first gate conductor and a second channel associated with the second gate conductor.

11. The method of Claim 10, wherein the first channel is above the second channel.

12. The method of Claim 8, 9, 10 or 11, further comprising forming an air gap between the first gate conductor and the second gate conductor.

13. The method of Claim 10, 11 or 12, wherein the first channel and the second channel has a nano-ribbon, a fin or a nanowire configuration.
